# EUROPEAN PATENT SPECIFICATION

(11) **EP 4 677 375 B1**
(45) Date of publication and mention of the grant of the patent: **01.04.2026**
(21) Application number: 24805098.1
(22) Date of filing: 19.09.2024
(51) Int. Cl.: G01R 31/34, G01R 31/40

(54) **METHOD OF DETECTING FAULT IN EXCITATION RECTIFIER OF SYNCHRONOUS GENERATOR**
VERFAHREN ZUR FEHLERERKENNUNG IN EINEM ERREGERGLEICHRICHTER EINES SYNCHRONGENERATORS
PROCÉDÉ DE DÉTECTION DE DÉFAUT DANS UN REDRESSEUR D'EXCITATION DE GÉNÉRATEUR SYNCHRONE

(30) Priority: 16.11.2023 CZ 20230448
(43) Date of publication of application: 14.01.2026
(73) Proprietor: Západoceská univerzita v Plzni, 30100 Plzen (CZ)
(72) Inventor: PEROUTKA, Zdenek, 31200 Plzen (CZ); CIBULKA, Jiri, 30100 Plzen (CZ)
(74) Representative: Zmeskal, Lukas
(86) International application number: PCT/CZ2024/050061
(87) International publication number: WO 2025/103532

(56) References cited:
- CN-A- 107 843 805
- LIU JIANYING ET AL: "Design and application for fault monitoring circuit of rotating rectifier in aviation brushless AC generator", PROCEEDINGS OF 2014 IEEE CHINESE GUIDANCE, NAVIGATION AND CONTROL CONFERENCE, IEEE, 8 August 2014 (2014-08-08), pages 1235 - 1239, XP032721924, ISBN: 978-1-4799-4700-3, [retrieved on 20150112], DOI: 10.1109/CGNCC.2014.7007379
- XINGZHEN ZHANG ET AL: "Fault Harmonic Analysis and Simulation of Rotating Rectifier Bridge of Nuclear Power Excitation System", 2023 IEEE INTERNATIONAL CONFERENCE ON POWER SCIENCE AND TECHNOLOGY (ICPST), IEEE, 5 May 2023 (2023-05-05), pages 49 - 54, XP034370687, DOI: 10.1109/ICPST56889.2023.10165585
- HUANG ZIGUO ET AL: "Analysis and diagnosis on open-circuit fault of diode rectifier in 12-phase synchronous generator system", 2014 16TH EUROPEAN CONFERENCE ON POWER ELECTRONICS AND APPLICATIONS, IEEE, 26 August 2014 (2014-08-26), pages 1 - 9, XP032651355, DOI: 10.1109/EPE.2014.6910864

## Description

### Field of the invention

The present invention relates to detection and also the determination of a type of fault in an excitation rectifier of a synchronous generator. The proposed invention is intended for the generators with external excitation.

### Background of the invention

A common method of diagnosing faults in a rectifier is, in most cases, based on continuous evaluation of the voltage drop across individual power electronics devices. During the rectifier operation, if there is a mismatch at the given power electronics device in between regularly alternating conduction phase, when the voltage on the power electronics device in forward (conductive) direction should be small, and the non-conduction phase, when either reverse or blocking voltage on the power electronics device should be significant, then the fault of the device is indicated. However, the described method uses rather complicated analogue circuits and may not be suitable for the rotary rectifiers mounted on a rotor of the brushless synchronous machines.

Another way of detecting a fault in a rectifier is to continuously measure the currents on their AC side and determine mean or rms value from the measured values of the phase currents. A fault is signalled in case of a disproportion of the rms or mean value between the phases, or if the values vary a lot from normal operation. However, in most cases, this method requires installation of additional current sensors not usually being part of the rectifiers, and similarly to the previous method, it cannot be used for the rotary rectifiers. Said principle is described, e.g., in article: N. M. A. Freire, J. O. Estima and A. J. Marques Cardoso, "Open-Circuit Fault Diagnosis in PMSG Drives for Wind Turbine Applications, " in IEEE Transactions on Industrial Electronics, vol. 60, no. 9, pp. 3957-3967, Sept. 2013, doi: 10.1109/TIE.2012.2207655*.* The pulse number of a diagnosed rectifier is used for some known rectifier fault diagnosis methods. The pulse number is defined as a ratio of the first harmonic AC component frequency of the rectified voltage to the first harmonic voltage on the AC side of the rectifier.

Unless the faults of the power electronics devices of the rotary rectifiers in the brushless synchronous generators are reliably detected, a rotary exciter is overloaded by current when the rms value of terminal voltage of the main synchronous generator is maintained, and enormously heated thereby. This results in faster aging of the rotary exciter insulation and can cause significant financial damage to the power plants where the machines are installed.

For example, documents ES2738649A1 and ES2738649B2 disclose technical solutions based on evaluation of the excitation system fault based on measurement of magnetic leakage field of the brushless synchronous generators. However, this method requires the installation of special sensors to measure the magnetic leakage field, which is not always an option and costs a lot of money.

JP2008295252 describes a fault detection and protection device for brushless synchronous machines, focusing on the DC excitation current supplied to the rotor via a rotary rectifier. The device analyses the DC component of the exciter field current and detects abnormal increases in superimposed AC components, which indicate failures of the rectifier's semiconductor elements. By digitally sampling this current, the system can distinguish between phase short-circuit and phase-open conditions. If a severe fault is confirmed, a stop command is issued; in less critical cases, constant DC excitation control prevents overexcitation without immediate shutdown. This method allows reliable monitoring of the DC excitation system without additional detection coils, ensuring simpler and more effective machine protection.

Document LIU JIANYING et al: "Design and application for fault monitoring circuit of rotating rectifier in aviation brushless AC generator" in PROCEEDINGS OF 2014 IEEE CHINESE GUIDANCE NAVIGATION AND CONTROL CONFERENCE, IEEE (2014-08-08), DOI: 10.1109/CGNCC.2014.7007379, ISBN: 978-1-4799-4700-3 describes a method of detecting fault in excitation rectifier of synchronous generator, wherein the field current is sampled, its harmonics calculated and used to indicate various types of faults in the excitation rectifier.

Document XINGZHEN ZHANG et al: "Fault harmonic analysis and simulation of rotating rectifier bridge of nuclear power excitation system ", 2023 IEEE INTERNATIONAL CONFERENCE ON POWER SCIENCE AND TECHNOLOGY (ICPST), IEEE, DOI: 10.1109/ICPST56889.2023.10165585 describes a method wherein the field current is sampled and harmonics calculated. Harmonic at 24 poles x 50Hz = 1200Hz remains relatively constant, whereas other, lower harmonics increase during a fault in the exciter caused by a failed rectifier diode.

Document CN107843805A describes a technical method for online fault diagnosis of rotating diodes in a brushless exciter. Two radial through-holes are drilled in the stator iron yoke between adjacent poles, and magnetic field measuring coils are installed in these holes. During operation, the induced voltage from the coils is collected with a data acquisition device and analyzed using real-time Fourier transform to extract the harmonic component corresponding to the armature's rotation frequency. This harmonic amplitude is compared against a predefined threshold, and if the value is exceeded, an open-circuit fault of a rotating diode is identified. The fault characteristic frequency depends on the rated speed of the exciter (e.g., 25 Hz at 1500 rpm, 50 Hz at 3000 rpm), making the method broadly applicable for real-time monitoring of diode faults.

Document HUANG ZIGUO et al: "Analysis and diagnosis on open-circuit fault of diode rectifier in 12-phase synchronous generator system ", 2014 16TH EUROPEAN CONFERENCE ON POWER ELECTRONICS AND APPLICATIONS, IEEE, DOI: 10.1109/EPE.2014.6910864 describes a rectifier for a DC power supply, where harmonics of the output DC voltage are calculated. A maximum 24^{th} harmonic is constant and used to normalize the sum of the 1^{st} to 23^{rd} harmonics, where the ratio λ is used for detecting various types of faults.

The invention described below makes it possible to reliably detect faults in the power electronics devices of the rotating and stationary rectifiers without the need to install additional special sensors and other measuring instruments.

### Summary of the invention

The present invention relates to a method of detecting faults in rectifiers which are operated in a fault-free state under continuous current mode at their DC side. In general, these are the rectifiers that are part of the excitation sources of the synchronous generators. For a diagnosed rectifier, a fault refers to a situation where a short circuit or open circuit occurs in the place of a faulty power electronics device. The detection method is based on evaluating the content of higher harmonics in the frequency spectrum of the measured signal. When diagnosing a failure in a rotary rectifier, the main measured quantity is the field (excitation) current entering the device with rotary magnetic coupling, whereas for stationary rectifiers, it is advantageous to use the complementary measurement of the rectified output voltage to detect the fault.

The frequency analysis of the measured signal (always current and complementary voltage) yields both the amplitude of the fundamental harmonic, of which frequency is equal to the frequency of the AC supply voltage of the rectifier being diagnosed, and all its non-zero integer multiples up to the value corresponding to the product of the fundamental harmonic and the pulse number *p* of the rectifier being diagnosed. The obtained amplitude values of the frequency spectrum of the quantity being measured up to the order (*p*-1) are normalized using *p*-th harmonic magnitude and summed up to get per-unit fault factor (in case of the current signal, the per-unit current fault factor is identified as *Xᵢ* and in case of the voltage signal, the per-unit voltage fault factor is identified as *Xᵤ*). In the next step, distance of the current value of the per-unit fault factor *Xᵢ* or *Xᵤ* from the fault-free condition is analyzed. When a pre-defined threshold value is exceeded, fault of the power electronics devices of the rectifier being diagnosed is signalled.

To reliably detect threshold fault states, terminal voltage of the powered synchronous generator is additionally sensed for the rotary rectifiers. For the rectifiers being diagnosed, a threshold fault state refers to a case where permanent short-circuit or permanent opening of at least one of DC poles of the rectifier from the load occurs on the DC terminals, said opening is occurring when permanent open circuit is occurring under fault for all power electronics devices belonging to either cathode or anode group of the rectifier.

To specify the faulty power electronics devices in the rotary rectifiers, it is sensed an angular displacement (position) of the rotor of the synchronous generator being powered, which is multiplied by the number of pole-pairs of the device with the rotary magnetic coupling that forms the rotary exciter together with the diagnosed rectifier. To specify the faulty power electronics devices in the stationary rectifiers, it is calculated the position of a space vector of the AC power supply voltage in the stationary coordinate system, usually using the Clark transform. The calculation of a space vector can be carried out throughout the operation of the rectifier, or just ad hoc after the fault detection. Based on the electrical angle of the diagnosed rectifier to be determined in this way, the device conduction angle in which the measured signal takes on an abnormal shape can be determined taking into account the control angle. For the rotary rectifiers, only anomalies in waveform of the field current of the device with rotary magnetic coupling, which forms the rotary exciter in combination with the diagnosed rotary rectifier, are examined. For the stationary rectifiers it is favourable to analyze anomalies in the waveform of the rectified voltage as well.

The excitation sources, which include the rectifiers that may be diagnosed based on the determined per-unit fault factor *Xᵢ* or *Xᵤ* usually have, including but not limited, one of the following topologies:
a) The excitation source comprises a stationary controlled thyristor rectifier, which is supplied from an AC source (usually an AC grid or other rotating AC source located on a common shaft with the synchronous generator), and of which DC terminals are electrically connected with the excitation (field) winding of a synchronous machine.
b) The excitation source comprises a rotary rectifier, of which DC terminals are electrically connected with the excitation (field) winding of a synchronous machine, and of which AC terminals are connected to a device with rotary magnetic coupling (usually to the rotary exciter of inverse synchronous type located on the common shaft with the synchronous machine), which is supplied either from AC source (usually an AC grid or other rotating AC source located on the common shaft with the synchronous generator) via the controlled rectifier, or via controlled DC source comprising a DC/DC converter.

The described method may be used to detect fault of one or more than one power electronics devices of the rectifier being diagnosed. For the rotary rectifiers, the type of fault is determined based on the rms value of terminal voltage of the synchronous generator, and by observing the per-unit current fault factor *Xᵢ* with pre-calculated or experimentally determined values for individual types of fault stored in a control computer. For stationary rectifiers, on the other hand, in addition to comparing the per-unit fault factor *Xᵢ* or *Xᵤ* with the pre-calculated or experimentally determined values, it is necessary to determine the mean current value on the DC side of the rectifier in order to determine the type of fault.

The described invention overcomes the existing solutions for the protection of rectifiers working in continuous current mode by the ability to reliably detect the fault and determine type thereof. The proposed solution is sufficient with common HW equipment of control computers (typically excitation controllers), does not require any additional instrumentation, and is very simple and robust in terms of its commissioning. The tuning consists of setting only one parameter, which is the per-unit current fault detection threshold *X_{i_threshold}.* If complementary per-unit voltage fault factor *Xᵤ* is used, the per-unit voltage threshold *X_{u_threshold}* must also be set.

### Explanation of drawings

The exemplary embodiment of the proposed invention, of which purpose is diagnosing faults of the power electronics devices of the rectifiers, which operate under continuous current mode, is described with reference to the drawings, in which:
Fig. 1 - is a configuration of connection of a synchronous generator with an excitation source comprising a stationary controlled thyristor rectifier;
Fig. 2 - is the configuration of connection of the synchronous generator with the excitation source comprising a device with a rotary magnetic coupling with a rotary rectifier connected to output thereof; an excitation system with the rotary magnetic coupling is either supplied from an AC source via the thyristor rectifier, or via a DC/DC converter.
Fig. 3 - is a block scheme describing an algorithm to detect faults of the power electronics devices of the stationary and rotary rectifiers operated under the continuous current mode.

### Exemplary embodiment of the invention

The exemplary embodiment describes applications in which the rectifiers usually operate under the continuous current mode, i.e., an essential condition for diagnosing of faults of their power electronics devices is met on the basis of the method specified in the present invention. These are the excitation circuit topologies of the synchronous generators 1, of which integral part of the excitation source 2 is either the stationary rectifier 7 or the rotary rectifier 4.

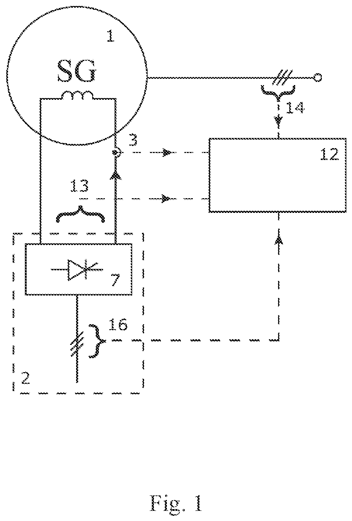

Fig. 1 illustrates the excitation source 2 variant for externally excited synchronous generators 1 with a wound rotor implemented through a stationary controlled thyristor rectifier 7. The stationary controlled thyristor rectifier 7 is supplied from an AC source (usually an AC grid or other rotating AC source located on a common shaft with the synchronous generator 1).

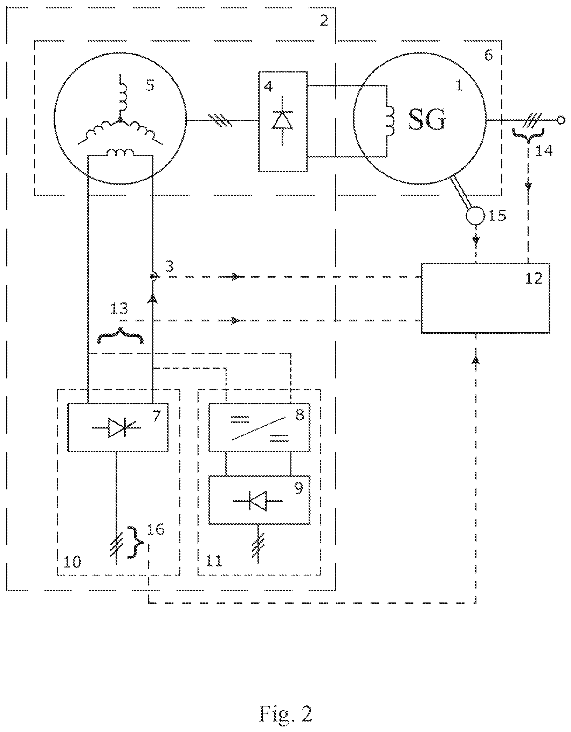

The proposed excitation rectifier fault diagnosis is suitable also for the excitation source 2 circuits used for the brushless synchronous generators illustrated in Fig. 2. The brushless synchronous generator 6 comprises an assembly consisting of a device with the rotary magnetic coupling 5 (usually a rotary exciter of inverse synchronous type located on a common shaft with the synchronous machine 1), rotary rectifier 4 and the synchronous generator 1. The device 5 with rotary magnetic coupling is supplied either from the AC source (usually the AC grid or other rotary AC source located on the common shaft with the synchronous generator 1) via the stationary controlled thyristor rectifier 7 (this is the method of supplying shown in the first power supply diagram 10), or via DC/DC converter 8 of which DC input terminals are connected to the AC source (usually to the AC grid or other rotary AC source located on the common shaft with the synchronous generator 1) via a diode rectifier 9, which is the second powering option shown in the second power supply diagram 11.

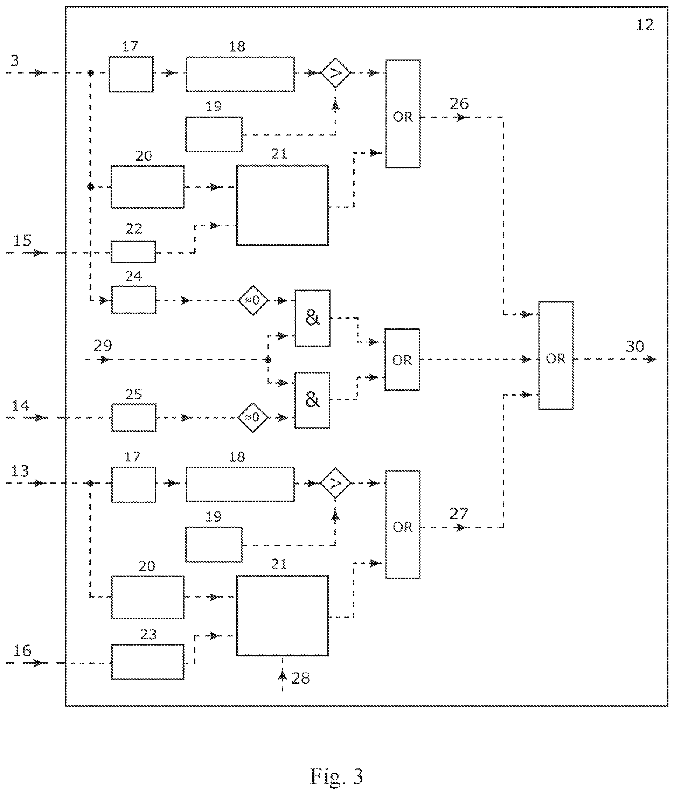

The principle of the rotary rectifier 4 and stationary rectifier 7 fault detection is based on frequency (Fourier) analysis of measured signal of field current 3 and voltage 13, respectively, where a fundamental harmonic amplitude calculation block 17 outputs amplitudes of all non-zero integer multiples of the fundamental harmonic frequency from the measured signal harmonic analysis up to the harmonic that equals to the product of fundamental harmonic and the pulse number *p* of the rectifier 4 or 7. The fundamental harmonic frequency equals to frequency of AC power supply voltage of the rectifier 4 or 7. The rectifier 4 or 7 power electronics devices fault diagnosis is performed using a per-unit current fault factor *Xᵢ* and/or per-unit voltage fault factor *Xᵤ,* refer to block 18 of the fault factor calculation. If the continuously evaluated per-unit current fault factor *Xᵢ* exceed the defined per-unit current fault detection threshold *X_{i_threshold}* or the per-unit voltage fault factor *Xᵤ* the defined per-unit voltage fault detection threshold *X_{u_threshold},* refer to block 19, for time more than one period of the basic harmonic frequency, the signal 26 indicates the rotary rectifier 4 fault or the signal 27 indicates the stationary rectifier 7 fault. As the source of the fault may be the rotary rectifier 4 or the stationary rectifier 7, the resulting signal 30 of the excitation source 2 fault is determined by logical summing of the signal 26 of the rotary rectifier 4 fault, signal 27 of the stationary rectifier 7 fault, and excitation procedure completion signal 29 after processing by the proposed logic illustrated in Fig. 3.

During normal operation of the synchronous generator 1 (i.e., excitation procedure of the synchronous generator 1 has been finished, which is indicated by the signal 29), the fault for the topology in Fig. 1 and Fig. 2 is detected also in case the DC component of the measured field current 3 is out of the permitted operation range.

Further, the fault is detected when the synchronous generator 1 excitation procedure is completed (refer to indication by the signal 29), and the rms value of back EMF of the generator 1 at field current 3, of which value is in the operation range defined for said synchronous generator 1, is lower than the rms value of the back EMF of the synchronous generator 1 dedicated for minimum permitted operating field current 3. To determine the described back EMF of the synchronous generator 1, the measured terminal voltage 14 is used.

An excitation procedure refers to a condition when the synchronous generator 1 achieved operational speed and the required field current 3 rises from 0 to required value derived from the grid voltage.

Tuning of the proposed method consists of setting of the per-unit current fault detection threshold *X_{i_threshold},* or the per-unit voltage fault detection threshold *X_{u_threshold},* refer to block 19. Tuning is conducted so that the per-unit fault factor *Xᵢ* or *Xᵤ* is measured in fault-free machine condition to determine the reference fault-free per-unit factor *X_{i_ref}* or *X_{u_ref}.* Further, the per-unit fault factor *Xᵢ* or *Xᵤ* is measured upon intentional fault where one power electronics device is not conducting in the rectifier 4 or 7. This determines the reference per-unit current fault factor *X_{i_err}* or reference per-unit voltage fault factor *X_{u_err}.* The per-unit fault detection threshold *X_{i_threshold}* or *X_{u_threshold}* is determined in block 19 by arithmetic mean of the values of reference fault-free per-unit current factor *X_{i_ref}* and the reference per-unit current fault factor *X_{i_err}* or of reference fault-free per-unit voltage factor *X_{u_ref}* and the reference per-unit voltage fault factor *X_{u_err}.*

The proposed method is capable of evaluating also type of the fault caused by short-circuit or by open-circuit of one or more power electronics devices of the rectifier 4 or 7. The type of fault is determined from size of the DC component of the field current 3 (block 24), rms value of the terminal voltage 14 of the synchronous generator 1 (block 25), and from comparison of the per-unit fault factor *Xᵢ* or *Xᵤ* (block 18) with pre-calculated or experimentally determined values for each type of excitation rectifier fault, stored in a control computer 12 (usually in an excitation controller). The block scheme in Fig. 3 clearly illustrates the algorithm for detection of the rectifier 7 or 2 power electronics device fault and the excitation source 2 failure. The fundamental diagnostic signals as described above are the field current 3 and the measured voltage 13 on the DC side of the stationary rectifier 7.

In order to specify the faulted power electronics devices, for the rotary rectifiers 4, the rotor displacement angle 1 of the powered synchronous generator 15 is sensed. The rotor displacement angle 15 is multiplied by the number pole pairs *pp* (refer to block 22) of the device 5 with rotary magnetic coupling that forms the rotary exciter together with the rotary rectifier 4 being diagnosed. To specify the faulty power electronics devices of the stationary rectifiers 7, the position of a space vector of the measured terminal voltage 16 of the AC source in the stationary coordinate system is calculated, usually using the Clark transform (refer to block 23). Based on the electrical angle of the diagnosed stationary rectifier 7 determined in this way, the device conduction angle (refer to block 21) in which the measured signal takes on an abnormal shape (refer to block 20) can be determined taking into account the control angle. For the rotary rectifiers 4, the anomalies (refer to block 20) in waveform of the field current 3 of the device 5 with rotary magnetic coupling are examined, which forms the rotary exciter in combination with the diagnosed rotary rectifier 4. For the stationary rectifiers 7 it is favourable to analyze the anomalies (refer to block 20) also in the waveform of the measured voltage 13 on the DC side of the stationary rectifier 7.

### List of reference numerals

- 1: synchronous generator
- 2: excitation source
- 3: field (excitation) current measured on stationary DC side of the excitation source 2, i.e., either field current on the stator of the device 5 with rotary magnetic coupling, or current on the DC side of the stationary rectifier 7;
- 4: rotary rectifier
- 5: device with rotary magnetic coupling (usually a rotary exciter of inversion synchronous type located on a common shaft with the synchronous generator 1)
- 6: brushless synchronous generator
- 7: stationary rectifier
- 8: DC/DC converter
- 9: diode excitation rectifier
- 10: first power supply block for powering of the device 5 with rotary magnetic coupling from an AC source (usually an AC grid or other rotating AC source located on a common shaft with the synchronous generator 1) via the stationary rectifier 7
- 11: second power supply block for powering of the device 5 with rotary magnetic coupling via the DC/DC converter 8, of which DC input terminals are connected to the AC source (usually the AC grid or other rotary AC source located on the common shaft with the synchronous generator 1) via the diode rectifier 9
- 12: control computer, usually an excitation controller in which algorithms for diagnosing of faults of the rotary rectifiers 4 and/or of stationary rectifiers 7 are implemented
- 13: measured voltage on the DC side of the stationary rectifier 7
- 14: terminal voltage of synchronous generator 1
- 15: synchronous generator 1 rotor displacement angle determined from a mechanical sensor
- 16: measured terminal voltage of AC source that powers the stationary rectifier 7
- 17: block for calculation of fundamental harmonic amplitude (FFT), of which frequency equals to frequency of AC supply voltage of the rectifier 4 or 7, and amplitude of all non-zero integer multiples of the fundamental harmonic frequency up to the harmonic, of which frequency equals to the product of the fundamental harmonic and pulse number of the rectifier 4 or 7
- 18: block for calculation of fault factor *X*, which is calculated by quotient, where denominator is amplitude of the highest determined frequency component of the measured field current 3 or measured voltage 13, and numerator is the sum of values of other lower determined frequency components of the field current 3 or measured voltage 13
- 19: fault detection threshold *X_{threshold}* being determined as arithmetic mean of reference fault-free per-unit factor *X_{ref}* determined in the fault-free condition of the rectifier being diagnosed, and factor *Xₑᵣᵣ* under fault where one power electronics device is not conducting in the rectifier 4 or 7
- 20: block that detects anomalies in the waveform of the measured field current 3 or measured voltage 13
- 21: block that determines cycle in which faulted power electronics device of the rectifier 4 or 7 would be active in fault-free condition based on electric angle value of the rectifier being diagnosed under which anomalous deformation in the waveform of the measured field current 3 or voltage 13 occurs,
- 22: number of pole-pairs *pp* of the device 5 with rotary magnetic coupling, used for continuous determination of electric angle of the rotary rectifier 4 as the product of number of pole-pairs *pp* and data about current rotor displacement angle 15 of the synchronous generator 1
- 23: space vector transform (usually using Clark transform) used to continuously determine electric angle of the stationary rectifier 7 as angle of space vector of its measured AC power voltage 16 expressed in stationary coordinate system
- 24: calculation of mean value from the waveform of the measured quantity
- 25: calculation of rms value from the waveform of the measured quantity
- 26: rotary rectifier 4 fault signal
- 27: stationary rectifier 7 fault signal
- 28: stationary rectifier 7 control angle
- 29: excitation procedure completion signal, synchronous generator 1 operation mode
- 30: excitation source 2 fault signal

## Claims

1. A method of detecting fault in excitation rectifier of synchronous generator (1) **characterized in that** field current (3) is measured on a stationary DC side of an excitation source (2), further, a frequency analysis based on the measured field current (3) determines
amplitude of fundamental harmonic, of which frequency equals to frequency of AC supply voltage of a rotary rectifier (3) that contains power electronics devices or of a stationary rectifier (7) that contains power electronics devices, and
amplitude of all non-zero integer multiples of the fundamental harmonic frequency up to the harmonic, of which frequency equals to the product of the fundamental harmonic and pulse number of the rectifier (4) or (7),
further, the quotient is used to calculate per-unit current fault factor *Xᵢ,* where denominator is amplitude of the highest determined frequency component of the measured field current (3), and numerator is the sum of values of other lower determined frequency components of the field current (3),
under fault-free condition, the reference fault-free per-unit current factor *X_{i_ref}* is calculated, followed by electric disconnection of at least one power electronics device of the rectifier (4), (7), and the reference per-unit current fault factor *X_{i_err}* is determined,
arithmetic mean of values of the reference fault-free per-unit current factor *X_{i_ref}* and reference per-unit current fault factor *X_{i_err}* are used to determine per-unit current fault detection threshold *X_{i_threshold},*
and in operation of the rectifier (4), (7), the per-unit current fault factor *Xᵢ* is continuously calculated, wherein the excitation source (2) fault is signalized in case that following the completion of the excitation procedure of the synchronous generator (1) indicated by signal (29)
- the per-unit current fault factor *Xᵢ* is higher than the per-unit current fault detection threshold *X_{i_threshold}* for time longer than one period of the fundamental harmonic frequency, and/or
- DC component of the measured field current (3) is out of the permitted operation range, and/or
- the rms value of the generator (1) back EMF is at a field current (3), of which value is within the permissible operating range defined for the synchronous generator (1), less than the rms value of the generator (1) back EMF determined for the minimum permissible operating field current (3), wherein the back EMF of the synchronous generator (1) is determined from the measured terminal voltage (14).

2. The method according to claim 1 **characterized in that** in addition, excitation source (2) fault type caused by short-circuit or by open-circuit of one or more power electronics devices of the rectifier (4), (7) is determined, when the size of DC component of the field current (3) and the rms value of the back EMF of the synchronous generator (1) is in permitted operating range, by comparison of continuously determined per-unit current fault factor *Xᵢ* with the values calculated or determined in experiments in advance, which are stored in a control computer (12) for each type of fault of the rectifier (4), (7).

3. The method according to claim 1 or 2 **characterized in that** in addition, the rectified voltage (13) is measured on the DC side of the stationary rectifier (7), a frequency analysis is used to determine the amplitude of the fundamental harmonic from the measured rectified voltage (13), the frequency of said harmonic being equal to frequency of AC supply voltage of the stationary rectifier (7), and amplitude of all non-zero integer multiples of the fundamental harmonic frequency up to the harmonic, of which frequency equals to the product of the fundamental harmonic and pulse number of the stationary rectifier (7),
further, the quotient is used to calculate per-unit voltage fault factor *Xᵤ*, where denominator is amplitude of the highest determined frequency component of the measured rectified voltage (13), and numerator is the sum of values of other lower determined frequency components of the rectified voltage (13),
under fault-free condition, the reference fault-free per-unit voltage factor *X_{u_ref}* is measured, followed by electric disconnection of at least one power electronics device of the stationary rectifier (7), and the per-unit voltage fault factor *X_{u_err}* is determined,
arithmetic mean of values of the reference fault-free per-unit voltage factor *X_{u_ref}* and reference per-unit voltage fault factor *X_{u_err}* is used to determine per-unit voltage fault detection threshold *X_{u_threshold},*
and in operation of the stationary rectifier (7), the per-unit voltage fault factor *Xᵤ* is continuously determined, wherein the stationary rectifier (7) fault is signalized in case that upon completion of the synchronous generator (1) excitation indicated by the signal (29), the per-unit voltage fault factor *Xᵤ* is higher than the per-unit voltage fault detection threshold *X_{u_threshold}* for time longer than one period of the fundamental harmonic frequency.

4. The method according to of previous claims 1 to 3 **characterized in that** at least one harmonic frequency is omitted in the sum of numerator in calculation (18) of the per-unit current fault factor *Xᵢ* and/or the per-unit voltage fault factor *Xᵤ.*

5. The method according to any of previous claims 1 to 4 **characterized in that** the measured terminal voltage (16) on the AC side of the stationary rectifier (7) is used for calculation of a space vector of voltage using Clark transform, the position of the space voltage vector is then compensated by subtracting the control angle of the stationary rectifier (7), the value of the position of the space vector of the terminal voltage (16) on the AC side of the stationary rectifier (7) deducted at the moment where an anomaly in the shape of measured waveform of the rectified voltage (13) compared to the fault-free condition is used to determine phase and/or specific power electronics device of the stationary rectifier (7) where the fault occurred.

6. The method according to any of previous claims 1 to 4 **characterized in that** the phase and/or specific power electronics device of the rotary rectifier (4) where the fault occurred, is determined from the synchronous generator (1) rotor displacement angle (15) multiplied by the number of pole-pairs *pp* (22) of the device (5) with the rotary magnetic coupling deduced at the moment when the anomaly in the shape of measured waveform of the field current (3) occurred with respect to the fault-free condition.

## Patentansprüche

1. Verfahren zur Erkennung eines Fehlers in einem Erregungsgleichrichter der Synchrongenerator (1), **dadurch gekennzeichnet, dass** ein Feldstrom (3) auf einer stationären Gleichstromseite einer Erregerquelle (2) gemessen wird, ferner bestimmt eine auf dem gemessenen Feldstrom (3) basierende Frequenzanalyse
die Amplitude der Grundschwingung, deren Frequenz der Frequenz der Wechselstromversorgungsspannung eines rotierenden Gleichrichters (4), der leistungselektronische Bauelemente enthält, oder eines stationären Gleichrichters (7), der leistungselektronische Bauelemente enthält, entspricht, und
die Amplituden aller ungleich Null ganzzahligen Vielfachen der Grundschwingungsfrequenz bis zur Oberschwingung, deren Frequenz dem Produkt aus der Grundschwingung und der Pulszahl des Gleichrichters (4) oder (7) entspricht,
ferner wird der Quotient zur Berechnung eines Per-Unit-Strom-Fehlerfaktors *Xᵢ* verwendet, wobei der Nenner die Amplitude der höchstbestimmten Frequenzkomponente des gemessenen Feldstroms (3) ist und der Zähler die Summe der Werte der anderen niedrigeren bestimmten Frequenzkomponenten des Feldstroms (3) ist,
unter fehlerfreien Bedingungen wird der fehlerfreie Referenz-Per-Unit-Stromfaktor *X_{i_ref}* berechnet, anschließend wird mindestens ein leistungselektronisches Bauelement des Gleichrichters (4), (7) elektrisch abgeschaltet, und der Referenz-Per-Unit-Strom-Fehlerfaktor *X_{i_err}* wird bestimmt,
das arithmetische Mittel der Werte des fehlerfreien Referenz-Per-Unit-Stromfaktors *X_{i_ref}* und des Referenz-Per-Unit-Strom-Fehlerfaktors *X_{i_err}* wird zur Bestimmung eines Per-Unit-Strom-Fehlererkennungsschwellenwerts *X_{i_threshold}* verwendet,
und während des Betriebs des Gleichrichters (4), (7) wird der Per-Unit-Strom-Fehlerfaktor *Xᵢ* fortlaufend berechnet, wobei ein Fehler der Erregerquelle (2) signalisiert wird, falls nach Abschluss des Erregungsverfahrens der Synchrongenerator (1) angezeigt durch ein Signal (29)
- der Per-Unit-Strom-Fehlerfaktor *Xᵢ* länger als über eine Periode der Grundschwingungsfrequenz größer als der Per-Unit-Strom-Fehlererkennungsschwellenwert *X*_{*i*_*threshold*} ist, und/oder
- eine Gleichstromkomponente des gemessenen Feldstroms (3) außerhalb des zulässigen Betriebsbereichs liegt, und/oder
- der Effektivwert der Gegen-EMK der Synchrongenerator (1) bei einem Feldstrom (3), dessen Wert innerhalb des für die Synchrongenerator (1) definierten zulässigen Betriebsbereichs liegt, kleiner ist als der Effektivwert der Gegen-EMK der Synchrongenerator (1), der für den minimal zulässigen Betriebs-Feldstrom (3) bestimmt ist, wobei die Gegen-EMK der Synchrongenerator (1) aus der gemessenen Klemmenspannung (14) bestimmt wird.

2. Verfahren nach Anspruch 1, **dadurch gekennzeichnet, dass** zusätzlich ein Fehlertyp der Erregerquelle (2), der durch Kurzschluss oder Unterbrechung eines oder mehrerer leistungselektronischer Bauelemente des Gleichrichters (4), (7) verursacht ist, bestimmt wird, wenn die Größe der Gleichstromkomponente des Feldstroms (3) und der Effektivwert der Gegen-EMK der Synchrongenerator (1) im zulässigen Betriebsbereich liegen, durch Vergleich des fortlaufend bestimmten Per-Unit-Strom-Fehlerfaktors *Xᵢ* mit den im Voraus berechneten oder experimentell bestimmten Werten, die in einem Steuerrechner (12) für jeden Fehlertyp des Gleichrichters (4), (7) gespeichert sind.

3. Verfahren nach Anspruch 1 oder 2, **dadurch gekennzeichnet, dass** zusätzlich die gleichgerichtete Spannung (13) an der Gleichstromseite des stationären Gleichrichters (7) gemessen wird, dass mittels einer Frequenzanalyse die Amplitude der Grundschwingung aus der gemessenen gleichgerichteten Spannung (13) bestimmt wird, wobei die Frequenz dieser Grundschwingung der Frequenz der Wechselstromversorgungsspannung des stationären Gleichrichters (7) entspricht, und dass die Amplituden aller ungleich Null ganzzahligen Vielfachen der Grundschwingungsfrequenz bis zur Oberschwingung bestimmt werden, deren Frequenz dem Produkt aus der Grundschwingung und der Pulszahl des stationären Gleichrichters (7) entspricht,
ferner wird der Quotient zur Berechnung eines Per-Unit-Spannungs-Fehlerfaktors *Xᵤ* verwendet, wobei der Nenner die Amplitude der höchstbestimmten Frequenzkomponente der gemessenen gleichgerichteten Spannung (13) ist und der Zähler die Summe der Werte der anderen niedrigeren bestimmten Frequenzkomponenten der gleichgerichteten Spannung (13) ist,
unter fehlerfreien Bedingungen wird der fehlerfreie Referenz-Per-Unit-Spannungsfaktor *X_{u_ref}* gemessen, anschließend wird mindestens ein leistungselektronisches Bauelement des stationären Gleichrichters (7) elektrisch abgeschaltet, und der Per-Unit-Spannungs-Fehlerfaktor *X*_{*u*_*err*} wird bestimmt,
das arithmetische Mittel der Werte des fehlerfreien Referenz-Per-Unit-Spannungsfaktors *X_{u_ref}* und des Referenz-Per-Unit-Spannungs-Fehlerfaktors *X_{u_err}* wird zur Bestimmung eines Per-Unit-Spannungs-Fehlererkennungsschwellenwerts *X_{u_threshold}* verwendet,
und während des Betriebs des stationären Gleichrichters (7) wird der Per-Unit-Spannungs-Fehlerfaktor *Xᵤ* fortlaufend bestimmt, wobei ein Fehler des stationären Gleichrichters (7) signalisiert wird, falls nach Abschluss der Erregung der Synchrongenerator (1) angezeigt durch das Signal (29) der Per-Unit-Spannungs-Fehlerfaktor *Xᵤ* länger als über eine Periode der Grundschwingungsfrequenz größer als der Per-Unit-Spannungs-Fehlererkennungsschwellenwert *X_{u_threshold}* ist.

4. Verfahren nach einem der vorangehenden Ansprüche 1 bis 3, **dadurch gekennzeichnet, dass** bei der Berechnung (18) des Per-Unit-Strom-Fehlerfaktors *Xᵢ* und/oder des Per-Unit-Spannungs-Fehlerfaktors *Xᵤ* in der Summe im Zähler mindestens eine Oberschwingungsfrequenz ausgelassen wird.

5. Verfahren nach einem der vorangehenden Ansprüche 1 bis 4, **dadurch gekennzeichnet, dass** die gemessene Klemmenspannung (16) an der Wechselstromseite des stationären Gleichrichters (7) zur Berechnung eines Spannungsraumzeigers unter Verwendung der Clarke-Transformation verwendet wird, wobei die Lage des Spannungsraumzeigers anschließend durch Subtraktion des Steuerwinkels des stationären Gleichrichters (7) kompensiert wird, wobei der Wert der Lage des Raumzeigers der Klemmenspannung (16) an der Wechselstromseite des stationären Gleichrichters (7), ermittelt zu dem Zeitpunkt, zu dem eine Anomalie in der Form des gemessenen Zeitverlaufs der gleichgerichteten Spannung (13) gegenüber dem fehlerfreien Zustand auftritt, dazu verwendet wird, die Phase und/oder das spezifische leistungselektronische Bauelement des stationären Gleichrichters (7) zu bestimmen, in dem der Fehler aufgetreten ist.

6. Verfahren nach einem der vorangehenden Ansprüche 1 bis 4, **dadurch gekennzeichnet, dass** die Phase und/oder das spezifische leistungselektronische Bauelement des rotierenden Gleichrichters (4), in dem der Fehler aufgetreten ist, aus dem Rotorversatzwinkel (15) der Synchrongenerator (1), multipliziert mit der Polpaarzahl pp (22) der Einrichtung (5) mit der rotierenden magnetischen Kupplung, ermittelt wird, wobei der Rotorversatzwinkel zu dem Zeitpunkt herangezogen wird, zu dem gegenüber dem fehlerfreien Zustand die Anomalie in der Form des gemessenen Zeitverlaufs des Feldstroms (3) auftritt.

## Revendications

1. Procédé de détection de défaut dans un redresseur d'excitation d'un générateur synchrone (1) **caractérisé en ce que** le courant de champ (3) est mesuré du côté CC stationnaire d'une source d'excitation (2), et qu'en outre une analyse fréquentielle basée sur le courant de champ mesuré (3) détermine
l'amplitude de l'harmonique fondamentale, dont la fréquence est égale à la fréquence de la tension d'alimentation CA d'un redresseur rotatif (4) contenant des dispositifs d'électronique de puissance ou d'un redresseur stationnaire (7) contenant des dispositifs d'électronique de puissance, et
l'amplitude de tous les multiples entiers non nuls de la fréquence de l'harmonique fondamentale jusqu'à l'harmonique dont la fréquence est égale au produit de l'harmonique fondamentale et du nombre d'impulsions du redresseur (4) ou (7),
en outre, un quotient est utilisé pour calculer un facteur de défaut de courant en unités relatives *Xᵢ*, dans lequel le dénominateur est l'amplitude de la composante fréquentielle déterminée la plus élevée du courant de champ mesuré (3), et le numérateur est la somme des valeurs des autres composantes fréquentielles déterminées, de fréquence inférieure, du courant de champ (3),
dans un état exempt de défaut, le facteur de courant en unités relatives de référence sans défaut *X_{i_ref}* est calculé, puis une déconnexion électrique d'au moins un dispositif d'électronique de puissance du redresseur (4), (7) est effectuée, et le facteur de défaut de courant en unités relatives de référence *X_{i_err}* est déterminé,
la moyenne arithmétique des valeurs du facteur de courant en unités relatives de référence sans défaut *X_{i_ref}* et du facteur de défaut de courant en unités relatives de référence *X_{i_err}* est utilisée pour déterminer un seuil de détection de défaut de courant en unités relatives *X_{i_threshold},*
et, pendant le fonctionnement du redresseur (4), (7), le facteur de défaut de courant en unités relatives *Xᵢ* est calculé en continu, un défaut de la source d'excitation (2) étant signalé dans le cas où, après l'achèvement de la procédure d'excitation du générateur synchrone (1) indiqué par un signal (29)
- le facteur de défaut de courant en unités relatives *Xᵢ* est supérieur au seuil de détection de défaut de courant en unités relatives *X_{i_threshold}* pendant une durée supérieure à une période de la fréquence de l'harmonique fondamentale, et/ou
- la composante continue du courant de champ mesuré (3) est en dehors de la plage de fonctionnement admise, et/ou
- la valeur efficace de la force électromotrice inverse du générateur (1) pour un courant de champ (3) dont la valeur est dans la plage de fonctionnement admissible définie pour le générateur synchrone (1) est inférieure à la valeur efficace de la force électromotrice inverse du générateur (1) déterminée pour le courant de champ (3) minimal admissible en fonctionnement, la force électromotrice inverse du générateur synchrone (1) étant déterminée à partir de la tension aux bornes mesurée (14).

2. Procédé selon la revendication 1 **caractérisé en ce qu'**en outre le type de défaut de la source d'excitation (2) provoqué par un court-circuit ou un circuit ouvert d'un ou de plusieurs dispositifs d'électronique de puissance du redresseur (4), (7) est déterminé, lorsque la valeur de la composante continue du courant de champ (3) et la valeur efficace de la force électromotrice inverse du générateur synchrone (1) sont dans la plage de fonctionnement admise, par comparaison du facteur de défaut de courant en unités relatives *Xᵢ* déterminé en continu avec les valeurs calculées ou déterminées expérimentalement à l'avance, qui sont stockées dans un ordinateur de commande (12) pour chaque type de défaut du redresseur (4), (7).

3. Procédé selon la revendication 1 ou 2 **caractérisé en ce qu'**en outre la tension redressée (13) est mesurée du côté CC du redresseur stationnaire (7), une analyse fréquentielle est utilisée pour déterminer l'amplitude de l'harmonique fondamentale à partir de la tension redressée mesurée (13), la fréquence dudit harmonique étant égale à la fréquence de la tension d'alimentation CA du redresseur stationnaire (7), et l'amplitude de tous les multiples entiers non nuls de la fréquence de l'harmonique fondamentale jusqu'à l'harmonique dont la fréquence est égale au produit de l'harmonique fondamentale et du nombre d'impulsions du redresseur stationnaire (7),
en outre, un quotient est utilisé pour calculer un facteur de défaut de tension en unités relatives *Xᵤ,* dans lequel le dénominateur est l'amplitude de la composante fréquentielle déterminée la plus élevée de la tension redressée mesurée (13), et le numérateur est la somme des valeurs des autres composantes fréquentielles déterminées, de fréquence inférieure, de la tension redressée (13),
dans un état exempt de défaut, le facteur de tension en unités relatives de référence sans défaut *X*_{*u*_*ref*} est mesuré, puis une déconnexion électrique d'au moins un dispositif d'électronique de puissance du redresseur stationnaire (7) est effectuée, et le facteur de défaut de tension en unités relatives *X_{u_err}* est déterminé,
la moyenne arithmétique des valeurs du facteur de tension en unités relatives de référence sans défaut *X*_{*u*_*ref*} et du facteur de défaut de tension en unités relatives de référence *X_{u_err}* est utilisée pour déterminer un seuil de détection de défaut de tension en unités relatives *X_{u_threshold},*
et, pendant le fonctionnement du redresseur stationnaire (7), le facteur de défaut de tension en unités relatives *Xᵤ* est déterminé en continu, un défaut du redresseur stationnaire (7) étant signalé dans le cas où, à l'achèvement de l'excitation du générateur synchrone (1) indiqué par le signal (29), le facteur de défaut de tension en unités relatives *Xᵤ* est supérieur au seuil de détection de défaut de tension en unités relatives *X_{u_threshold}* pendant une durée supérieure à une période de la fréquence de l'harmonique fondamentale.

4. Procédé selon l'une quelconque des revendications précédentes 1 à 3 **caractérisé en ce qu'**au moins une fréquence harmonique est omise dans la somme du numérateur dans le calcul (18) du facteur de défaut de courant en unités relatives *Xᵢ* et/ou du facteur de défaut de tension en unités relatives *Xᵤ.*

5. Procédé selon l'une quelconque des revendications précédentes 1 à 4 **caractérisé en ce que** la tension aux bornes mesurée (16) du côté CA du redresseur stationnaire (7) est utilisée pour calculer un vecteur spatial de tension au moyen de la transformation de Clarke, la position du vecteur spatial de tension est ensuite compensée en soustrayant l'angle de commande du redresseur stationnaire (7), la valeur de la position du vecteur spatial de la tension aux bornes (16) du côté CA du redresseur stationnaire (7) relevée à l'instant où une anomalie dans la forme de l'onde mesurée de la tension redressée (13), par rapport à l'état exempt de défaut, se produit, est utilisée pour déterminer la phase et/ou le dispositif d'électronique de puissance spécifique du redresseur stationnaire (7) dans lequel le défaut s'est produit.

6. Procédé selon l'une quelconque des revendications précédentes 1 à 4 **caractérisé en ce que** la phase et/ou le dispositif d'électronique de puissance spécifique du redresseur rotatif (4) dans lequel le défaut s'est produit est déterminé à partir de l'angle de déplacement du rotor (15) du générateur synchrone (1) multiplié par le nombre de paires de pôles pp (22) du dispositif (5) avec le couplage magnétique rotatif, relevé à l'instant où l'anomalie dans la forme de l'onde mesurée du courant de champ (3) s'est produite par rapport à l'état exempt de défaut.
